# EUROPEAN PATENT APPLICATION

(11) **EP 1 895 578 A1**
(43) Date of publication of application: **05.03.2008**
(21) Application number: 06425606.8
(22) Date of filing: 01.09.2006
(51) Int. Cl.: H01L 21/311, H01L 21/8247, H01L 27/115

(54) **Manufacturing method of an integrated circuit formed on a semiconductor substrate**

(71) Applicant: STMicroelectronics S.r.l., 20041 Agrate Brianza MI (IT)
(72) Inventor: Bresolin, Camillo, 20059 Vimercate (Milano) (IT); Erbetta, Davide, 24047 Treviglio (Bergamo) (IT); Marangon, Maria Santina, 23807 Merate (Lecco) (IT)
(74) Representative: Ferrari, Barbara

(57) **Abstract**

Method for manufacturing an integrated circuit (101; 102; 1) formed on a semiconductor substrate (201; 2) comprising the steps of:
- forming at least one shielding structure (60; 61; 6A, 6B) on said semiconductor substrate (201; 2),
- forming a protective layer (100, 190; 19, 11') at least on portions of the semiconductor substrate (201; 2) that surround said shielding structure (60; 6A, 6B),
- carrying out a ionic implantation step with a tilt angle with respect to a normal to a plane defined by said semiconductor substrate (201; 2) so that said at least one shielding structure (60; 61; 6A, 6B) shields first portions (200; 202; 20, 11A) of the protective layer (100, 190; 19, 11'),
- removing second portions (210; 211; 21, 11B) of the protective layer (100, 190; 19, 11') that have been subjected to the ionic implant.

## Description

### Field of application

The present invention relates to a method for manufacturing an integrated circuit formed on a semiconductor substrate.

The invention particularly, but not exclusively, relates to a method for manufacturing non volatile memory electronic devices wherein some portions must be shielded or covered with a protective layer and the following description is made with reference to this field of application for simplifying the illustration only.

### Prior art

As it is well known, conventional methods for patterning a layer of material formed on a semiconductor substrate comprise, for example, the steps of:
- formation or deposition of the layer to be patterned on the semiconductor substrate,
- deposition of a photosensitive layer on the layer to be patterned,
- photolithographic exposure of the photosensitive layer,
- removal of the photosensitive layer for forming a photolithographic mask,
- etching step of the layer to be patterned through the photolithographic mask,
- removal of the photolithographic mask.

This conventional patterning method although being particularly efficient, shows some drawbacks.

For example the high management costs associated with the photolithographic processes.

Moreover, the photosensitive layer is generally formed by organic materials that can contaminate the layer to be patterned.

Finally, this method shows limits on the dimensions of the areas to be patterned due both to the minimum resolution that can be realised in the photolithpgraphic mask ("Dimensional Control") and to the difficulty of alignment of the mask to structures that could be already present on the substrate ("overlay").

Japanese patent application JP60240131 describes another method for patterning an oxide insulating material formed on a semiconductor substrate. In particular, on the layer of insulating material a photolithographic mask is formed which shields portions of the layer of insulating material to be patterned, while portions of the layer of insulating material to be removed are subjected to ionic implantation so that the etching rate of these latter portions is quicker with respect to the shielded regions.

However, also this method shows the same drawbacks of the previous patterning methods.

In particular, the difficulty of aligning the masks to structures that could be already present on the substrate is particularly evident when layers are to be patterned inside memory devices.

It is known that non volatile memory electronic devices, for example of the Flash type, integrated on semiconductor substrate, comprise non volatile memory cells, organised in matrix of rows, called word lines, and columns, called bit lines.

Each single non volatile memory cell comprises a MOS transistor wherein the gate electrode, placed above the channel region, is floating, i.e. it has a high impedance in DC towards all the other terminals of the same cell and of the circuit wherein the cell is inserted. The floating gate electrode is insulated from the semiconductor substrate by means of an active oxide layer called tunnel.

The cell comprises also a second electrode, called control gate, which is capacitively coupled to the floating gate electrode through an intermediate dielectric layer, so called interpoly. This second electrode is driven by means of suitable-control voltages. The other electrodes of the transistor are the usual drain, source terminals. The floating gate electrode and the control gate one are generally formed by a polysilicon layer.

The cells belonging to a same word line share the electric line which drives the respective control gates, while the cells belonging to a same bit line share the drain terminals. In particular, in the memory matrixes of last generation, portions of the word lines aligned to the floating gate electrodes realise the control gate electrodes of the memory cells.

Conventionally, the memory cell matrix is associated with a control circuitry which comprises conventional MOS transistors each one having a source region and a drain region separated by a channel region. A gate electrode is thus formed on the channel region and insulated therefrom by means of a gate oxide layer. This gate electrode is generally formed by a polysilicon layer.

It is also known that, for significantly reducing the resistance of the interconnections and of the contact areas in the active areas of the single electronic devices, composite materials are used comprising silicon and a transition metal such as titanium, tungsten, cobalt or nickel. These composite materials are called silicides and are used for realising layers with relatively low resistivity.

At present the self-aligned salicidation process applied to a memory electronic device comprising a matrix of memory cells provides the salicidation of all the exposed silicon active areas, i.e. of the source/drain regions, and of the polysilicon lines both of the circuitry area and of the matrix area.

This process occurs, after the patterning step of the transistors of the circuitry and of the matrix cells, by means of a removal step of residual silicon oxide layer grown or deposited by all the active areas and the polysilicon lines which are to be salicidised.

This removal step is followed by the deposition of a metallic layer, by a thermal treatment suitable for the formation of the silicide layer to which the selective removal of the non reacted metal is made follow. The salicidation of the source/drain regions of the cells of the matrix implies the presence of a metallic silicide layer near the tunnel active oxide layer of the floating gate electrode potentially dangerous both for possible effects of induced stress and for the high mobility in the silicon substrate of metallic elements typically used in the salicidation processes, as cobalt and nickel.

For this reason it is preferred or necessary to avoid the presence of the silicide layer on the drain/source regions of the matrix cells, maintaining however the possibility of having this silicide layer on the WordLine and thus on the control gate electrodes of the memory cells and in the circuitry areas outside the matrix.

A first known technical solution for shielding the regions of the device wherein it is suitable that the silicide layer is not formed is that of depositing on the whole electronic device a dielectric material layer.

This dielectric material layer is then patterned by means of a photolithographic technique which provides the use of a photolithographic mask and removed by means of dry etching by the regions wherein the silicide layer is to be realised.

Although advantageous under several aspects, this first solution however shows several drawbacks. In fact due to the complex morphology and density of a matrix of memory cells it can be difficult to remove the layer of dielectric material only from the regions wherein the salicidation is to be carried out and however it would require the use of a lithographic mask suitably generated and introduced in the manufacturing process flow, implying a significant complication and increase of the costs with respect to the conventional process flows.

The technical problem underlying the present invention is that of devising a method for manufacturing an integrated circuit formed on a semiconductor substrate, wherein a layer of material formed on the semiconductor substrate is patterned without using a conventional photolithographic process, and thus having such structural characteristics as to avoid the use of additional photolitographic masks, succeeding in overcoming the limits and/or drawbacks still limiting the patterning method of the prior art such as, for example, the difficulties of patterning small areas ("CD control") and the alignment inaccuracies of a mask with respect to the structures generated with previous masks ("overlay").

### Summary of the invention

The solution idea underlying the present invention is that of providing a method for manufacturing an integrated circuit formed on a semiconductor substrate wherein first portions of a protective layer are patterned by means of tilted implantation. In particular, the protective layer is formed on the whole integrated circuit, thus, by means of tilted ionic implantation, the etch-rate of second portions of this protective layer to be removed is selectively altered, and subsequently these second portions are removed while the first portions of this protective layer are not removed.

On the basis of this solution idea the technical problem is solved by a method as previously indicated and defined by the characterising part of claim 1.

The characteristics and the advantages of the method according to the invention will be apparent from the following description of an embodiment thereof given by way of indicative and non limiting example with reference to the annexed drawings.

### Brief description of the drwaings

In these drawings:
- figures 1 to 3 show portions of an integrated circuit during some process steps of a first embodiment of the method according to the invention,
- figures 4 to 6 show portions of an integrated circuit during some process steps of a second embodiment of the method according to the invention,
- figures 7 to 12 show portions of an integrated circuit during some process steps of a third embodiment of the method according to the invention,
- figures 13 to 15 show portions of an integrated circuit during some process steps of a fourth embodiment of the method according to the invention.

### Detailed description

With reference to these figures, a method is described for manufacturing an integrated circuit formed on a semiconductor substrate, in particular a method for patterning a protective layer formed on the semiconductor substrate.

The process steps and the structures described hereafter do not form a complete process flow for the manufacturing of integrated circuits.

The figures showing cross sections of portions of an integrated circuit during the manufacturing are not drawn to scale, but they are instead drawn so as to show the important characteristics of the invention.

The present invention can be put into practice together with the manufacturing techniques of the integrated circuits currently used in the field, and only those process steps being commonly used and necessary for the comprehension of the present invention are included.

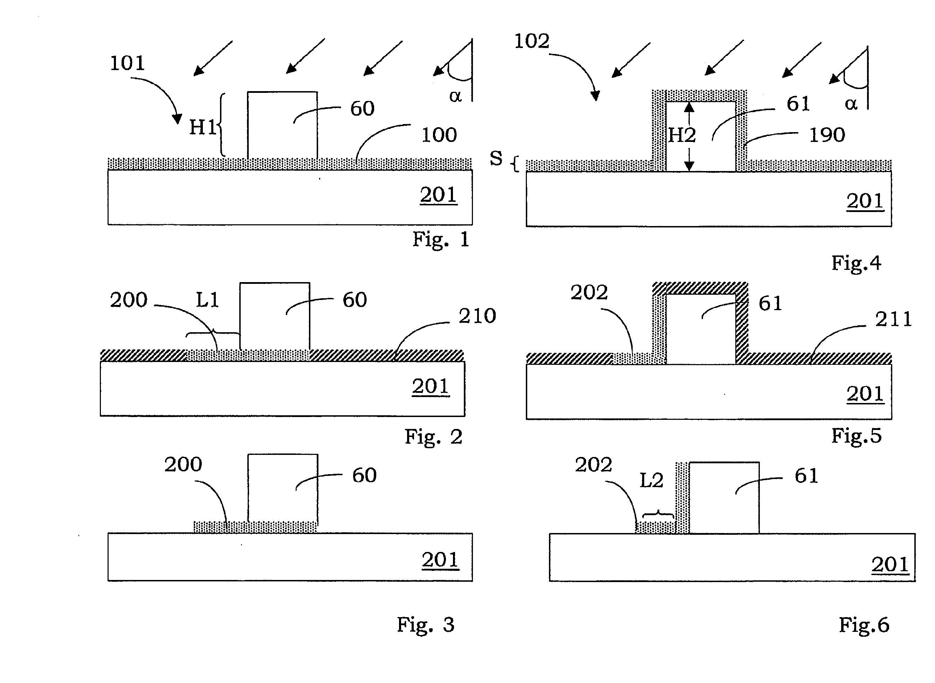

In particular, with reference to figure 1, an integrated circuit 101 is shown wherein a protective layer 100 is formed on a substrate 201. Advantageously, this substrate 201 comprises a semiconductor layer, for example of silicon.

Advantageously, the protective layer 100 is a dielectric layer for example of silicon oxide. Advantageously, the protective layer 100 has a thickness comprised between 50 and 500 Å, preferably 100 Å.

Advantageously, the protective layer 100 is a layer of silicon nitride. If the protective layer 100 is formed by a layer of silicon nitride; this protective layer 100 has a thickness comprised between 50 and 150 Å, preferably 70 Å i.e. thinner than a corresponding protective layer of silicon oxide.

A shielding structure 60 is formed on the protective layer 100.

Advantageously, the shielding structure 60 comprises one or more material layers. Advantageously, these material layers can be selectively etched with respect to the protective layer 100.

Advantageously, the shielding structure 60 is part of an electronic device provided in a conventional process flow to form integrated circuits on a substrate. In this way, the alignment problems of the protective layer 100 to be patterned are reduced with respect to the shielding structure 60. However, in other embodiments of the method according to the invention the shielding structure 60 is a structure suitably realised on the protective layer 100.

According to the invention, a ionic implantation step is carried out with tilt or angle α with respect to a normal to a plane defined by the substrate 201 so that the shielding structure 60 shields first portions 200 of the protective layer 100 placed on the substrate 201 which are in the "shadow area" produced by the shielding structure 60, as shown in figure 2.

In other words, considering that the shielding structure 60 has a first height H 1 with respect to the substrate 201 and that the ionic implantation step is carried out with tilt angle α, the first portions 200 of the protective layer 100 which are along the tracks of the ions meeting the shielding structure 60 will not be implanted.

Therefore, there will be no implantation of first portions 200 of the protective layer 100 placed on the substrate 201 and being adjacent to one side shielding structure 60 placed in the "shadow area" produced by the shielding structure 60 and having a length L1 equal to the height H1, multiplied by the tangent of the tilt angle α.

Advantageously according to the invention, the length L1 of the first portions 200 is strictly linked to the width of the angle α. The smaller is the angle α, the narrower the first portions 200 will be. Thus, with the method according-to the invention, it is possible to define first portions 200, adjacent to a structure 60 already present on the substrate 201, with length L1 shorter than the one that can be patterned with conventional photo-lithographic techniques.

Therefore, according to the invention, during the implantation step, the first portions 200 of the protective layer 100 are shielded and thus they do not undergo implantation, while second non shielded portions 210 of the protective layer 100 are implanted. Thus the etch-rate of these second portions 210 is changed with respect to the first portions 200.

In particular, the inclined ionic implantation step induces, in a selective way, a different etch-rate in the second portions 210 of the protective layer 100 which are implanted. Advantageously species, energy and dose used in the implantation step must be such as to induce a sufficient damage or doping in the second portions 210 of the protective layer 100 so as to alter, in a significant way, their etch-rate with respect to the first portions 200 during a successive etching step.

For example, the implanted dopant is arsenic, germanium, silicon, or other element or molecule able to modulate the characteristics of etching speed of the protective layer 100 to be patterned.

For example, the dopant is implanted with a dose comprised between 1x10¹² at/cm² and 1x10¹⁶ at/cm², advantageously from 5x10¹³ at/cm² to 5x10¹⁴ at/cm² if the dopant is arsenic and an energy comprised between 1 keV and 500 keV, advantageously from 30 to 50 keV if the dopant is arsenic.

Advantageously, the tilt angle α with respect to the normal to the plane defined by the substrate 201, with which the ionic implantation step is carried out, varies in a range between 30° and 60°.

As shown in figure 3, according to the invention, a removal step is then carried out of the second portions 210 of the protective layer 100, for example through a chemical etching step, leaving the first portions 200 to protect the substrate 201.

The removal step is for example carried out by means of chemical etching of the wet or also "dry" type; in any case it is sufficient that the etching is sensitive to the different doping or damage of the layer.

If the protective layer 100 is formed by a silicon oxide layer, the chemical etching advantageously occurs in a solution of diluted hydrofluoric acid (HF) which allows the possibility of modulating the etching speed according to the thickness to be removed and ensuring an excellent reproducibility and productivity of the method according to the invention.

In particular, by means of a bath in diluted HF solution, the second portions 210 of silicon oxide damaged by the implantation step are etched and removed more quickly that the first portions 200 of non damaged oxide. It is then possible to adjust the etching step in HF so as to remove all the second portions 210 of damaged oxide without reaching a complete removal of the portions 200 of non damaged oxide.

Advantageously according to the invention, if the protective layer 100 is formed by a silicon nitride layer, the etch-rate of the first portions 200 is remarkably different from the etch-rate of the second portions 210, allowing a removal step of these latter second portions 210 being much more selective with respect to the one wherein the protective layer 100 is realised for example with a silicon oxide layer.

With reference to figures 4 to 6, a second embodiment of the method according to the invention is described, in which a protective layer 190 is formed or deposited above the shielding structures 61.

In particular, with reference to figure 4, an integrated circuit 102 is shown wherein a shielding structure 61 is formed on a substrate 201.

Advantageously, this substrate 201 comprises a semiconductor layer, for example of silicon.

Advantageously, the shielding structure 61 comprises one or more layers of material. Advantageously, these layers of material can be selectively etched with respect to the protective layer.

A protective layer 190 is formed or deposited on the substrate 201 and on the shielding structure 61.

Advantageously, the shielding structure 61 is part of an electronic device provided in a conventional process flow to form circuits integrated on a substrate. In this way the alignment problems of the protective layer 190 to be patterned with respect to the shielding structure 61 are reduced. In some embodiments of the invention, the shielding structure 61 is instead a structure suitably realised on the substrate 201.

Advantageously, the protective layer 190 is a dielectric layer for example of silicon oxide.

Advantageously, the protective layer 190 has a thickness S comprised between 50 and 500 Å preferably 100 Å.

Advantageously, the protective layer 190 is a silicon nitride layer. If the protective layer 190 is formed by a silicon nitride layer, this protective layer 190 has a thickness comprised between 50 Å and 150 Å, preferably 70 Å i.e. thinner with respect to a corresponding protective layer of silicon oxide.

Advantageously, the protective layer 190 is a conformal layer so as to follow the profile of the shielding structure 61.

According to the invention, a ionic implantation step is carried our with a tilt o with angle α with respect to a normal to a plane defined by the substrate 201 so that the shielding structure 61 shields first portions 202 of the protective layer 190 placed on the substrate 201 and on the side walls of the shielding structure 61 which are in the "shadow area" produced by the shielding structure 61 and by the protective layer covering it, as shown in figure 5.

In other words, considering that the shielding structure 61 has a height H2 with respect to the substrate 201, the protective layer 190 has a thickness equal to S, and that the ionic implantation step is carried out with tilt angle α, the first portions 202 of the protective layer 190 which are along the tracks of the implanted ions which meet the shielding structure 61 covered by the protective layer 190 will not be implanted.

Therefore, first portions 202 of the protective layer 190 placed on the substrate 201 which are adjacent to a side of the shielding structure 61 in the "shadow area" produced by the shielding structure 61 and by the protective layer and which have a length L2 equal to the thickness S summed to the height H2 multiplied by the tangent of the tilt angle α will not be implanted, while the first portions 202 of the protective layer 190 placed on the side walls of the shielding structure 61 will have length equal to H2, supposing that the implanted ions do not succeed in penetrating into the protective layer 190 for a greater depth of the thickness S.

Advantageously according to the invention, the length L2 of the first portions 202 is strictly linked to the width of the angle α. The smaller the angle α is, the narrower the first portions 210 will be. Thus, with the method according to the invention, it is possible to pattern first portions 202 with shorter length L2 than the one that can be patterned with conventional photo-lithographic techniques.

Therefore according to the invention, during the implantation step, the first portions 202 of the protective layer 190 are shielded and thus do not undergo implantation, while second non shielded portions 211 of the protective layer 190 are implanted. The etch-rate of these second portions 211 is thus changed with respect to the first portions 202.

The modes the implantation step is carried out are the same as those by which the implantation step is carried out in the previous embodiment.

As shown in figure 6, according to the invention, a removal step is carried out of the second portions 211 of the protective layer 190, for example through a chemical etching step, leaving the first portions 202 to protect the substrate 201 and the side walls of the shielding structures 61.

The modes by which the removal step is carried out are the same as those by which the removal step is carried out in the previous embodiment.

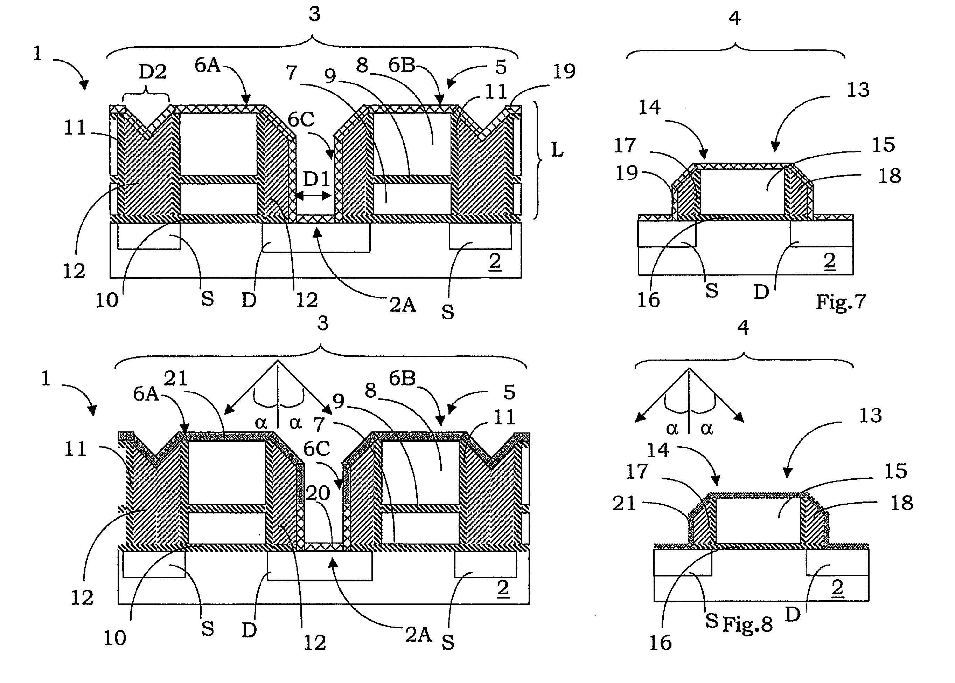

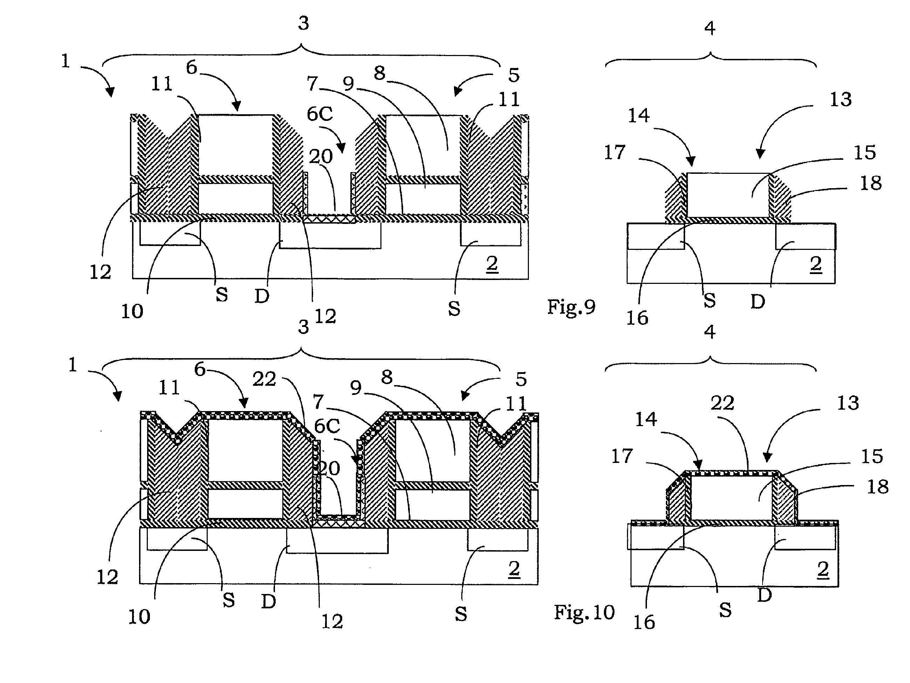

A third embodiment of the method according to the invention is described with reference to figures 7 to 13.

In particular, with reference to figure 7, an integrated circuit 1 is shown formed on a semiconductor substrate 2, for example of silicon. The integrated circuit 1 comprises a first portion 3 and, advantageously, a second portion 4.

In the first portion 3 a first plurality of electronic devices 5 is formed, for example non volatile memory cells. Each of these electronic devices 5 is provided with a region 6 projecting from the semiconductor substrate 2, formed for example by one or more conductive layers 7, 8 being electrically insulated from each other, by means of a first insulating layer 9. Each region 6 is insulated from the semiconductor substrate 2 by means of a second insulating layer 10. Advantageously, a third insulating layer 11 coats at least the walls of each region 6 and coats portions of the semiconductor substrate 2 comprised between adjacent projecting regions 6.

Advantageously, the conductive layers 7, 8 are formed by polysilicon layers and the insulating layers 9, 10 and 11 are formed by layers of silicon oxide or silicon nitride or a combination thereof.

The devices 5 are then completed with the formation of respective source and drain regions S and D.

Advantageously, insulating spacers 12 are formed on the side walls of the regions 6 projecting from the semiconductor substrate 2.

Advantageously, the insulating spacers 12 are formed by a silicon nitride layer.

In particular, the electronic devices 5 formed in the first portion 3 are not equidistant.

For example, groups of projecting regions 6 are separated from each other by first openings which expose portions of protective layers between adjacent regions 6 belonging to a same group. Moreover, at least one first region 6A and one second region 6B belonging to different groups, are separated from each other by a second opening 6C which exposes a portion 2A of the semiconductor substrate 2.

Advantageously, since the width D2 of the first openings is smaller than the double of the width of each single spacer 12 realised on the side walls of the electronic devices 5 formed in the first portion 3, the first openings are completely filled in by the spacer 12.

Moreover, the width D1 of the second openings 6C is such as to allow to realise, inside, a via for the contacting of the substrate.

Advantageously, in the second portion 4 of the integrated circuit 1 a second plurality of electronic devices 13 is formed, for example of conventional transistors. Each of these electronic devices 13 is provided with a region 14 projecting from the semiconductor substrate 2, formed for example by at least one conductive layer 15. This region 14 is insulated from the semiconductor substrate 2 by means of a first insulating layer 16.

Advantageously, a second insulating layer 17 coats at least the walls of each region 14.

Advantageously, the conductive layer 15 is formed by a polysilicon layer and the insulating layers 16, 17 are formed by silicon oxide layers.

The devices 13 are completed with the formation of respective source and drain regions S and D.

Advantageously, insulating spacers 18, are formed on the side walls of the regions 14 projecting from the semiconductor substrate 2.

The process steps to form these first and second electronic devices 5, 13 on the semiconductor substrate 2 are known to the skilled person and thus they are not here reported in detail to avoid a burdening of the following description.

In this embodiment of the method according to the invention, after having removed the insulating layer 11 that could be present on the portion 2A of the semiconductor substrate 2, a protective layer 19 is formed or deposited on the whole integrated circuit 1.

This protective layer 19 is a conformal layer, i.e. it perfectly follows the profile of the electronic devices 5, 13 realised on the semiconductor substrate 2, and in particular, coats the second openings 6C.

Advantageously, the protective layer 19 is formed by a dielectric layer for example of silicon oxide.

Advantageously, the protective layer 19 has a thickness comprised between 50 Å and 500 Å, preferably 100 Å.

Advantageously, the protective layer 19 is a silicon nitride layer. If the protective layer 19 is formed by a silicon nitride layer, this protective layer 19 has a thickness comprised between 50 Å and 150 Å, preferably 70 Å i.e. thinner with respect to a corresponding protective layer of silicon oxide, being particularly indicated for applications in which the regions 6 are very close to each other.

According to the invention, a ionic implantation step is carried out with a tilt or with angle α with respect to a normal to a plane defined by the semiconductor substrate 2 so that the first region 6A shields first portions 20 of the protective layer 19 placed on the side walls and on the bottom of said opening 6C which are in the "shadow area" produced by the first region 6A.

In other words, the first portions 20 of the protective layer 19 which are along the tilted tracks of the implanted ions which meet the first region 6A covered by the protective layer 19 will not be implanted.

Therefore according to the invention, during the implantation step, the first portions 20 of the protective layer 19 are shielded and thus are not subjected to implantation, while second non shielded portions 21 of the protective layer 19 are implanted. The etch-rate of these second portions 21 are thus change with respect to the first portions 20.

Advantageously, the tilt angle α with respect to the normal to the plane defined by the semiconductor substrate 2 varies in a range between 30° and 60°.

The modes by which the implantation step is carried out are the same as those by which the implantation step is carried out in the previous embodiment.

In particular, by carrying out a single implantation, the portions 20 of the protective layer 19 are not symmetrically conformed inside the openings 6C; in a similar way, with reference to the structures 4, portions of protective layer 19 are, after this first implantation step, shielded by the implant due to the shadow effect.

Advantageously, this first implantation step is followed by a second implantation step with a tilt which forms an angle α with respect to the normal to the plane defined by the semiconductor substrate 2, which is however on the opposite side with respect to the tilt angle of the first ionic implantation, so that said second region 6B shields the second portions 20 of the protective layer 19 placed on the side walls and on the bottom of said opening 6C.

Advantageously, the tilt angle with respect to the normal to the plane defined by the semiconductor substrate 2 varies in a range between - 30° and -60°.

The mode by which this second implantation step is carried out are the same as those by which the first implantation step is carried out.

By carrying out these two implantation steps, the portions 20 of the protective layer 19 will be symmetrically conformed inside the openings 6C, as shown in figure 7.

In particular, the first and the second regions 6A, 6B belonging to the first portion 3 of the integrated circuit 1 are close to each other so as to shield the portions 20 of the protective layer 19 in the opening 6C during the ionic implantation step, while the regions 14 projecting in the second portion 4 of the integrated circuit 1 are sufficiently spaced from each other so that the whole protective layer 19 formed in the second portion 4 of the integrated circuit 1 is completely implanted during the two implantation steps.

According to the invention, a removal step is then carried out of the second portions 21 of the protective layer 19, for example through a chemical etching step, until at least one conductive layer 8 of the regions 6 projecting from the first portion 3 of the integrated circuit 1 is exposed.

The modes by which this removal step is carried out are the same by which the removal step is carried out in the previous embodiments of the method according to the invention.

Advantageously, in the second portion 4 of the integrated circuit 1, the removal step of the portions 21 of the protective layer 19 exposes at least the conductive layer 15 of the projecting regions 13, and portions of the semiconductor substrate 2 comprised between these projecting regions 13 not coated by the spacers 18.

Nothing forbids that in the second portion 4 of the integrated circuit 1 there are however electronic devices having respective regions projecting from the semiconductor substrate 2, separated from each other by an opening which exposes a portion of the semiconductor substrate 2, so that, during the ionic implantation step, first portions 20 of the protective layer 19 are not implanted and remain to protect the bottom and the side walls of the opening, as it occurs for the electronic devices of the first portion 3.

In particular, during the ionic implantation step, first portions 20 of the protective layer 19 remain to protect the bottom and the side walls of openings which separate regions projecting from the semiconductor substrate 2 which have an aspect ratio substantially identical to that of the second openings 6C of the first portion 3 of the integrated circuit 1, where aspect ratio is the ratio between the depth L and the width D1 of the second openings 6C.

If the electronic devices 5 are non volatile memory cells organised in matrix of rows, called word lines, and columns, called bit lines, the direction of the projection of the beam of ions implanted on the plane of the substrate (twist angle) is preferably perpendicular to the direction of the word lines so as to maximise the shadow effect of the structures 6A and 6B for a determined tilt angle α.

As already highlighted, the second openings 6C, in this latter embodiment, are thus formed in correspondence with the drain regions D of the memory cells.

The first portions 20 of protective layer 19 having been patterned, by means of implantation and etching step, the integrated circuit 1 can be advantageously subjected to other process steps necessary for the completion of the integrated circuit 1.

For example the process flow is completed by the salicidation step with the self-aligned technology.

In particular, a layer 22 of a transition metal is deposited on the whole surface of the substrate, and then a thermal process is carried out during which the layer 22 of a transition metal selectively reacts with the surface of the exposed semiconductor substrate 2, i.e. in the areas not covered by protective layers as the spacers 12, 18 and the portions 20 of the protective layer 19, and with the surface of the conductive layers 8, 15 to form a silicide layer 23 according to the normal modes provided by the techniques of silicide self-aligned formation.

Then the process for manufacturing the integrated circuit 1 is completed by the deposition of premetal dielectric layers 24, contacts 25 and metallisations.

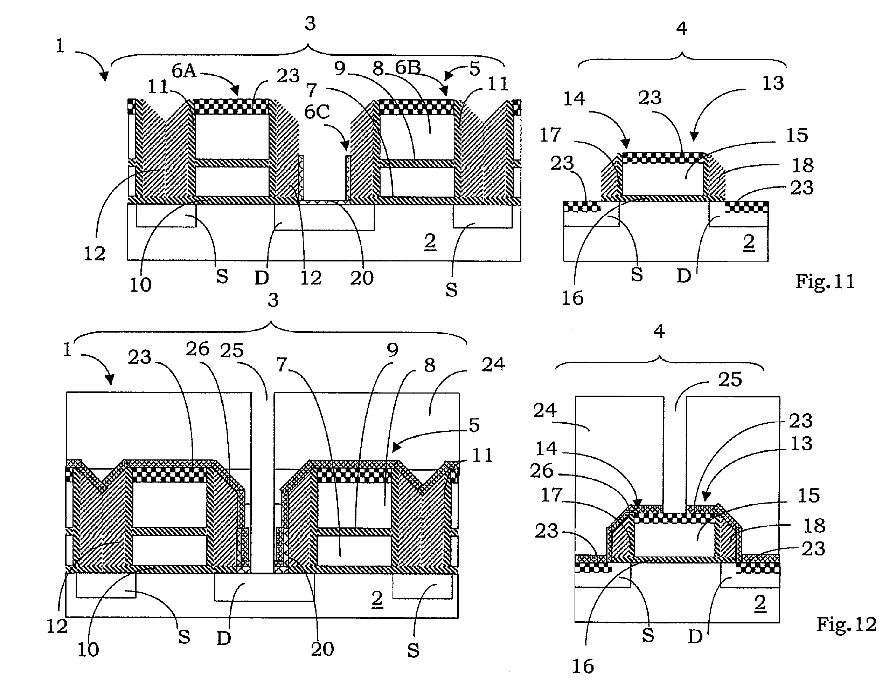

Advantageously according to the invention, the suitable choice of thickness of the protective layer 19, the parameters of the implantation step and length of the etching step does not prevent the formations of at least one contact 25 inside the second openings 6C, by means of plugs of tungsten or other material, also in case of a manufacturing process flow providing the successive formation of a borderless nitride layer 26 on the whole integrated circuit 1 before the formation of the pre-metal dielectric layers 24, as shown in figure 12.

Advantageously according to this embodiment, not only portions 20 of the layer 19 formed on the semiconductor substrate 2 are patterned, but also portions 20 formed on the side walls of the regions 6A or/and 6B. In this way not only the semiconductor substrate 2 is shielded by the portions 20, but also conjunction portions between the semiconductor substrate 2 and the side walls of the regions 6A or/and 6B ensuring a stronger protection of these critical areas of the integrated circuit 1.

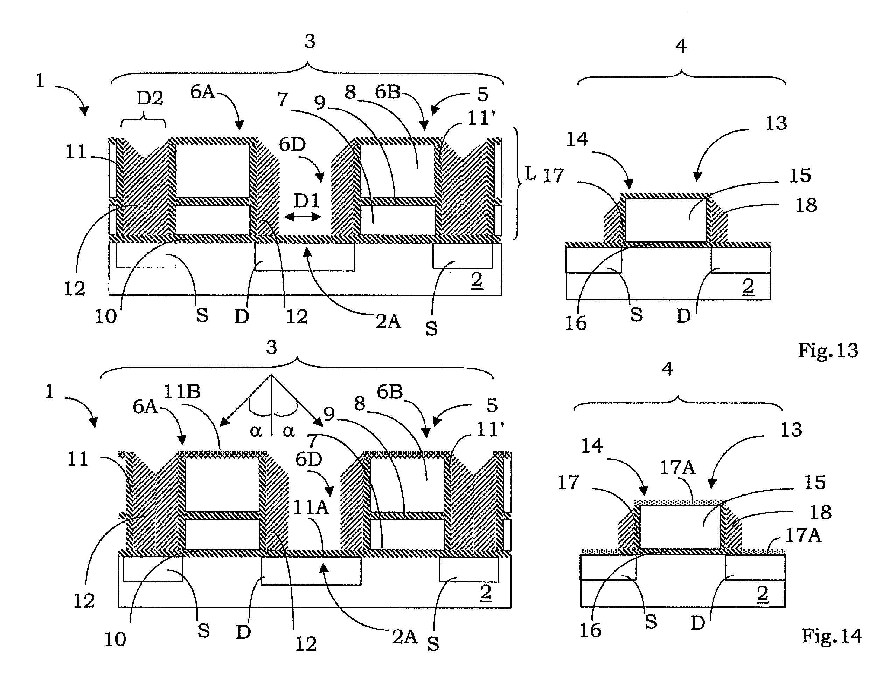

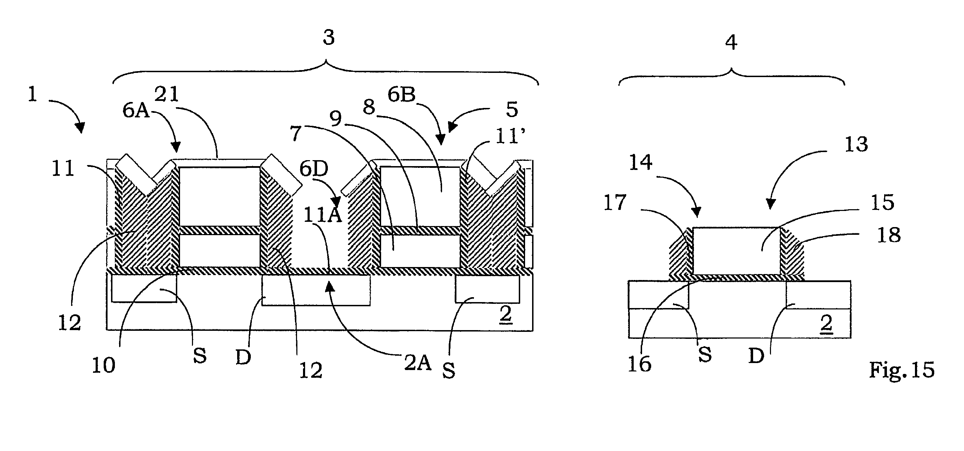

A fourth embodiment of the method according to the invention without the use of a protective layer 19 deposited ad hoc is described with reference to figures 13 to 15. In these figures, portions of the integrated circuit having the same functions of portions of the integrated circuit of the previous embodiment are indicated with the same reference numbers.

In particular, with reference to figure 13, an integrated circuit 1 is shown formed on a semiconductor substrate 2, for example of silicon. The integrated circuit 1 comprises a first portion 3 and, advantageously, a second portion 4.

In the first portion 3 a plurality of electronic devices 5 is formed, for example non volatile memory cells.

Each of these electronic devices 5 is provided with a region 6 projecting from the semiconductor substrate 2, formed for example by one or more conductive layers 7, 8 being electrically insulated from each other by means of a first insulating layer 9. Each region 6 is insulated from the semiconductor substrate 2 by means of a second insulating layer 10.

Advantageously, a third insulating layer 11', for example of silicon oxide, completely coats each region 6 and covers portions of the semiconductor substrate 2 comprised between adjacent projecting regions 6.

Nothing forbids that the insulating layer, which covers the portions of the semiconductor substrate 2 comprised between adjacent projecting regions 6, is formed together with other dielectric layers already present in the conventional process flow for realising the integrated circuit 1, such as for example the active oxide layer 10.

Advantageously, the conductive layers 7, 8 are formed by polysilicon layers and the other insulating layers 9 and 10 are formed by layers of oxide or silicon nitride or a combination thereof.

The electronic devices 5 are then completed with the formation of respective source and drain regions S and D.

Advantageously, insulating spacers 12 are formed on the side walls of the regions 6 projecting from the semiconductor substrate 2.

Advantageously, the insulating spacers 12 are formed by a nitride layer.

In particular, the electronic devices 5 formed in the first portion 3 are not equidistant.

For example, groups of projecting regions 6 are separated from each other by first opening that expose portions of protective layers present between adjacent regions 6 belonging to a same group. Moreover, at least one first region 6A and one second region 6B belonging to different groups are separated from each other by a third opening 6D which exposes a portion 11A of the insulating layer 11'.

Advantageously, since the width D2 of the first openings is smaller than the width of each single spacer 12 realised on the side walls of the electronic devices 5 formed in the first portion 3, the first openings are completely filled in by the spacers 12.

Moreover, the width D1 of the third openings 6D is such as to house a via for a contact.

Advantageously, in the second portion 4 of the integrated circuit 1 a second plurality of electronic devices 13 is formed, for example conventional transistors. Each of these electronic devices 13 is provided with a region 14 projecting from the semiconductor substrate 2, formed for example by at least one conductive layer 15. This region 14 is insulated from the semiconductor substrate 2 by means of a first insulating layer 16.

Advantageously, a second insulating layer 17 coats each region 14. Advantageously, portions of the insulating layer 17 cover the portions of the semiconductor substrate comprised between the electronic devices 13.

Advantageously, the conductive layer 15 is formed by a polysilicon layer and the insulating layers 16, 17 are formed by silicon oxide layers.

The devices 13 are completed with the formation of respective source and drain regions S and D.

Advantageously, insulating spacers 18 are formed on the side walls of the regions 14 projecting from the semiconductor substrate 2.

In this embodiment of the method according to the invention, a portion of the insulating layer 11' is used for shielding the semiconductor substrate exposed portion 2A which is comprised between adjacent devices 5, for example the semiconductor substrate portion wherein the drain region of the memory cells is realised.

According to the invention, a ionic implantation step is carried out with a tilt or with angle α with respect to a normal to a plane defined by the semiconductor substrate 2 so that the first region 6A shields the portion 11A of the insulating layer 11', while surface portions 11B of the insulating layer 11' of the first circuit portion 3 and surface portions 17A of the insulating layer 17 of the second circuit portion 4 are subjected to the ionic implantation.

The modes by which the implantation step is carried out are the same as those by which the implantation step is carried out in the previous embodiment.

Advantageously, this first implantation step is followed by a second implantation step with a tilt opposed with respect to the normal to the plane of the semiconductor substrate 2 if it is necessary to eliminate the shield effect of the implants themselves by the electronic devices 13 in the second portion 4 of the integrated circuit 1.

Advantageously, the tilt angle with respect to the normal to the plane defined by the semiconductor substrate 2 varies in a range between - 30° and -60°.

The modes by which this second implantation is carried out are the same as those by which the first implantation step is carried out.

Therefore, according to the invention, during the implantation steps, the portion 11A of the insulating layer 11' which covers the portion 2A of the semiconductor substrate 2 is shielded and thus are not subjected to implantation, while all the other surface portions 11B and 17A of the integrated circuit 1 are implanted, as shown in figure 14.

According to the invention, a removal step of implanted surface portions is then carried out, for example by means of chemical etching step, until at least one conductive layer 8 of the projecting regions 6 and the conductive layers 15 and the active areas of the devices 13 are exposed.

The modes by which this removal step are the same as those by which the removal step is carried out in the previous embodiments of the method according to the invention.

The device can then be completed for example with the formation of a self-aligned silicide and successive metallisations following the process steps already exposed for the previous embodiment.

In further embodiments of the latter embodiments described, the regions 6 can be shielding structures suitably realised on the semiconductor substrate 2.

Definitely, with the method according to the invention, which provides at least the steps of forming a protective layer 100, 190; 19, 11' on at least portions of a substrate which at least surround one shielding structure formed on the substrate itself, of carrying out a ionic implantation step with a tilt angle with respect to a normal to a plane defined by the substrate so that the shielding structure shields first portions of the protective layer, and of removing second portions of the protective layer which have been subjected to the ionic implantation, it is possible to generate a pattern of the protective layer formed on the substrate, without the costs relative to a lithographic process and with a self-alignment with respect to the structures present on the substrate since it is not generated through an additional mask but through the use of pre-existing structures.

Moreover, the method according to the invention - with suitable tilt angles and with suitable structures - can generate patterns with greater patterning capacities than those which can be litographically obtained.

Therefore, according to the invention, the manufacturing method described allows to define portions of protective layers, for example to shield portions of the semiconductor substrate from successive steps of the manufacturing process without resorting to photolithographic processes.

In particular, if the shielding structures 60, 61, 6A, 6B are non volatile memory cells organised in matrix, the method according to the invention allows to avoid, if necessary, the growth of metallic silicide layers in regions of the electronic device being too close to the layer 10 of the tunnel oxide of the memory cell 5 thus avoiding problems of functionality of the memory device linked to effects of induced stress of the silicide layer 23 or degrade of the tunnel active oxide layer 10 due to the diffusion of the transition metal in the semiconductor substrate 2, for example cobalt and nickel. At the same time, the invention allows, inside the same memory cell matrix, the complete formation of the silicide on the word-line areas 23, allowing a closeness between the areas with silicide 23 and the protective areas without silicide under the drain contact 25 according to a scheme that cannot be obtained by using the normal patterning techniques of protective layers through photolithographic processes. In particular, a photolithographic process is not used for generating the portions 20 that will be used as shield and the portions 21 that must be removed.

In conclusion, the method according to the invention is an alternative patterning technique with respect to known photolithographic processes which attains the following advantages:
- reduced costs,
- elimination possible contamination from organic materials used by the lithographic process,
- possibility of patterning very small areas - also smaller than the areas that can be lithographically patterned, so called "CD control",
- possibility of varying the etch rate on areas being perfectly aligned to structures previously defined, this property is generally defined of self-alignment (overlay = 0) and constitutes a significant advantage with respect to the solution by means of photolithographic process; in particular, this aspect is exploited in the latter two embodiments, which refer to memory cells wherein the drain contact area is protected from the silicide formation selectively with respect to the word lines which will be instead non protected and thus with silicide.

Moreover, the compatibility of the method according to the invention with the processes for manufacturing the integrated circuits currently in use is complete.

## Claims

1. Method for manufacturing an integrated circuit (101; 102; 1) formed on a substrate (201; 2) comprising the steps of:
- forming at least one shielding structure (60; 61; 6A, 6B) on said substrate (201; 2), the method **characterised in that** is comprises the following steps:
- forming a protective layer (100, 190; 19, 11') at least on portions of the substrate (201; 2) that surround said shielding structure (60; 6A, 6B),
- carrying out a ionic implantation step with a tilt angle with respect to a normal to a plane defined by said substrate (201; 2) so that said at least one shielding structure (60; 61; 6A, 6B) shields first portions (200; 202; 20, 11A) of the protective layer (100, 190; 19, 11'),
- removing second portions (210; 211; 21, 11B) of the protective layer (100, 190; 19, 11') that have been subjected to the ionic implant.

2. Method for manufacturing an integrated circuit (101; 1) according to claim 1, **characterised in that** said protective layer (100; 11') is formed before of said at least one shielding structure (60; 6A, 6B).

3. Method for manufacturing an integrated circuit (102; 1) according to claim 1, **characterised in that** said protective layer (190; 19) coats said at least one shielding structure (61; 6A, 6B).

4. Method for manufacturing an integrated circuit (101; 102; 1) according to claim 1, **characterised in that** said shielding structure (60; 61; 6A) is formed by a first region projecting from a semiconductor substrate (2) which is part of electronic devices (5) formed in a first portion (3) of said integrated circuit (1).

5. Method for manufacturing an integrated circuit (1) according to claim 4, **characterised in that** the following steps:
- forming at least one second region (6B) projecting from said semiconductor substrate (2) of said electronic devices (5), said first region (6A) and second region (6B) being insulated from said semiconductor substrate (2) by means of an insulating layer (10) and comprising at least one conductive layer (7, 8), said first region (6A) being separated -from the second region (6B) by an opening (6C) which exposes a portion (2A) of said semiconductor substrate (2),
- wherein said protective layer (19) is formed on said at least one first and second region (6A, 6B) and on the side walls and on the bottom of said opening (6C), and wherein during said ionic implantation step said first region (6A) shields said first portions (20) of the protective layer (19) placed on the side walls and on the bottom of said opening (6C), and wherein the removal of second portions (21) of the protective layer (19) that have been subjected to the ionic implant exposes said at least one conductive layer (8).

6. Method for manufacturing an integrated circuit (1) according to claim 5, **characterised in that**, before the removal step of said second portions (21) of the protective layer (19), the method comprises the step of:
- carrying out a further ionic implantation step with a tilt angle which is opposed to the normal to the plane of the semiconductor substrate so that said second region (6B) shields second portions (20) of the protective layer (19) placed on the side walls and on the bottom of said opening (6C).

7. Method for manufacturing an integrated circuit (1) according to claim 1, **characterised in that** said protective layer (100, 190; 19, 11') is formed by a silicon oxide layer.

8. Method for manufacturing an integrated circuit (1) according to claim 7, **characterised in that** the removal step of said second portions (21) of the protective layer (19) occurs in a solution of diluted hydrofluoric acid (HF).

9. Method for manufacturing an integrated circuit (1) according to claim 5, **characterised in that** said electronic devices (5) are non volatile memory cells, organised in matrix of rows, called word lines, and columns, called bit lines.

10. Method for manufacturing an integrated circuit (1) according to claim 9, **characterised in that** during the ionic implantation step the direction of the projection-of the beam of ions implanted on the plane of the semiconductor substrate (twist angle) is perpendicular to the direction of said word lines.

11. Method for manufacturing an integrated circuit (1) according to claim 5, **characterised in that** said at least one conductive layer (7, 8) is formed by a polysilicon layer.

12. Method for manufacturing an integrated circuit (1) according to claim 5, **characterised in that** it comprised the following steps:
- forming a layer (22) of a transition metal on said whole integrated circuit (1);
- carrying out a thermal process during which said layer (22) of a transition metal selectively reacts with exposed portions of said semiconductor substrate (2) not covered by said first portions (20) of the protective layer (19) and on said at least one conductive layer (8) to form a silicide layer (23).

13. Method for manufacturing an integrated circuit (1) according to claim 4, 5 or 12, **characterised in that** said integrated circuit (1) comprises a second portion (4) comprising electronic devices (13) with regions (14) projecting from the semiconductor substrate (2) which during the formation step of said protective layer (19) are coated by said protective layer (19), said protective layer (19) being implanted and then subsequently removed together with the second portions (21) of the protective layer (19) formed in the first portion (3) of the integrated circuit (1).

14. Method for manufacturing an integrated circuit (1) according to claim 13 **characterised in that** electronic devices (13) of said second portion (4) comprise at least one polysilicon layer (15) which is exposed during the removal step of said second portions (21) of the protective layer (19)

15. Method for manufacturing an integrated circuit (1) according to claim 1 **characterised in that** said protective layer (100, 190; 19, 11') is formed by a silicon nitride layer.
